# EUROPEAN PATENT SPECIFICATION

(11) **EP 0 615 335 B1**
(45) Date of publication and mention of the grant of the patent: **25.11.1998**
(21) Application number: 94106855.3
(22) Date of filing: 06.04.1988
(51) Int. Cl.: H02P 7/29, H02M 7/527, H03K 7/08

(54) **Switch mode electrical power controller**
Elektrischer Leistungsschaltregler
Régulateur de puissance électrique à commutation

(30) Priority: 09.04.1987 GB 8708504
(43) Date of publication of application: 14.09.1994
(62) Divisional of application: 88303074.4
(73) Proprietor: SEAGATE MICROELECTRONICS LTD., Livingston EH54 7BW, Scotland (GB)
(72) Inventor: Martin-Lopez, Fernando Ramon, Mountain View, California 94040 (US)
(74) Representative: Darby, David Thomas

(56) References cited:
- EP-A- 0 182 621
- DE-A- 3 227 296
- GB-A- 1 205 923
- US-A- 3 902 140
- US-A- 3 978 424
- IBM TECHNICAL DISCLOSURE BULLETIN, vol.25, no.3A, August 1982, N.Y.USA pages 1057 - 1058 C.D.DRISCOLL 'Pulse-width modulator'
- PATENT ABSTRACTS OF JAPAN vol. 6, no. 99 (E-111) (977) 8 June 1982 & JP-A-57 032 126 (MATSUSHITA DENKI SANGYO K.K.) 20 February 1982

## Description

The present invention relates to a switch mode electrical power controller.

Switch mode electrical power controllers are used in electrical power supplies. An electrical power supply for an electrical system including active semiconductor or vacuum devices is usually required to provide a substantially constant output voltage from a rectified alternating voltage while an electrical power supply for an electrical motor may be required to provide a variable output voltage for the control of the motor speed. Thus the controller for an electrical power supply may be required to provide for either the generation of a stabilised output voltage or a variable output voltage from an unstabilised input voltage.

An electrical power supply employing a switch mode controller operates by chopping the input voltage, passing to its output port either the full input voltage or zero voltage. The periods with a non-zero output voltage alternate with those of zero output voltage and the ratio of the two periods is varied as required to make the long term average voltage equal to the desired output voltage.

One of the advantages of a switch mode electrical power supply over other forms of electrical power supply is that the operating frequency may, within limits, be selected, and the fact that the energy storage components become smaller as the operating frequency is increased permits some control over the size of the power supply.

German Patent Application No.32 27 296 discloses a pulse width modulator (PWM) circuit for a switching regulator in which the PWM circuit includes a first comparator which compares an input signal with a sawtooth wave signal, a second comparator which compares a reference voltage with the sawtooth wave signal, an AND circuit which receives the outputs from the first and second comparators and a reference voltage generator which includes series-connected first and second resistors; a capacitor is connected in parallel with one of the resistors and the reference voltage is obtained from the connection point between the resistors, a preferred arrangement including, further, a switch circuit so connected to the resistors that the reference voltage may be lowered by an electrical signal applied to the switch circuit.

United States Patent Application No. 3 978 424 discloses a two-phase pulse generator which includes a first triangular signal generator in the form of a closed-loop oscillator, a second triangular signal generator for generating a signal which is inverted with respect to the first triangular signal and a pair of comparators for comparing the two triangular wave signals with a common control signal representative of a control requirement, two-phase pulse signals being obtained from the two comparators and the time duration of each of the pulse signals being proportional to the common control signal.

An object of the present invention is the provision of a switch mode electrical power controller capable of operation at higher frequencies than existing switch mode electrical power controllers.

The invention provides a switch mode electrical power controller including a signal generator which, in operation, provides a repetitively occurring ramp waveform signal, a control input port for receiving a control input signal which represents the required output voltage from a power supply, a signal processing network including means capable of performing pulse width modulation by combining the ramp waveform signal with the control input signal and at least one other signal and, from the combination, providing a repetitive output signal having a first level for a first part of its period and a second level for the remainder of its period, a first circuit arrangement connecting the output of the means capable of performing pulse width modulation to an input of the means capable of performing pulse width modulation, a change in a first sense in the repetitive output signal being fed back by the first circuit arrangement to the means capable of performing pulse width modulation and reinforcing the change in the output of the means capable of performing pulse width modulation in the first sense.

Preferably, the signal generator generates a ramp waveform that includes abrupt transitions, an additional circuit arrangement is connected between the signal generator and the first circuit arrangement and, in operation, the additional circuit arrangement transmits the abrupt transitions of the ramp waveform signal to the means capable of performing pulse width modulation for resetting the means capable of performing pulse width modulation at each abrupt transition of the ramp waveform signal.

Preferably, the means capable of performing pulse width modulation includes a comparator providing inverting and non-inverting input ports and the first circuit arrangement is connected between the the output port and a non-inverting input port of the comparator.

Preferably, a buffer stage connects the output port of the comparator to the first circuit arangement.

In one embodiment, the signal processing network includes an output stage providing an input port which is connected directly to the output port of the means capable of performing pulse width modulation, a feedback network connecting an input port of the means capable of performing pulse width modulation to the output stage and a feedforward network connecting the signal generator to an input port of the means capable of performing pulse width modulation.

In one embodiment, the feedback network includes input regions of the output stage.

In one embodiment, the signal processing network includes similar first and second channels for providing respective first and second output signals on the first and second channels, and commutation and blanking networks are connected in shunt with the signal processing network for selecting either the first or the second output signal for transmission to an output port of the controller.

In an alternative embodiment, the signal processing network includes first and second channels for providing respective first and second output signals on the first and second channels, and a commutation network is connected in shunt with the signal processing network for combining the first and the second output signals for transmission to an output port of the controller.

Preferably, the signal generator is a non-saturating emitter-coupled multivibrator.

Preferably, the signal processing network includes current and voltage limit protection networks connected in shunt with the remainder of the signal processing network.

Preferably, the signal processing network includes a plurality of differentially-connected transistor stages with common-mode input ports, differential-mode input ports and differential mode output ports.

Preferably, the signal processing network includes a signal level setting network connected to adjust the control signal range.

A switch mode electrical power controller in accordance with the present invention will now be described by way of example only and with reference to the accompanying drawings, in which:-
Fig. 1 is a block diagram representation of a first form of switch mode electrical power controller, in accordance with the present invention, including a ramp waveform generator, a signal processing network with two channels, and an output stage connected to each channel of the signal processing network,
Fig. 2 is a diagrammatic representation of the waveforms provided by the ramp waveform generator, the signal processing network, and the output stages of the controller of Fig. 1,
Fig. 3 is a circuit diagram representation of the ramp waveform generator of Fig. 1,
Fig. 4 is a diagrammatic representation of the ramp waveforms provided by the ramp waveform generator of Fig. 3,
Fig. 5 is a block diagram representation of a second form of switch mode electrical power controller, in accordance with the present invention, in which the signal processing network and the output stages are arranged differently from the signal processing network and output stages of Fig. 1,
Fig. 6 is a circuit diagram representation of part of the signal processing network of Fig. 5 capable of carrying out the functions of pulse-width modulation and output signal switching, latching, and resetting,
Fig. 7 is a circuit diagram representation of another part of the signal processing network of Fig.5 capable of carrying out the circuit functions of commutation and blanking,
Fig. 8 is a circuit diagram representation of an arrangement of the signal processing network for providing a single-ended output from the controller, and,
Fig. 9 is a circuit diagram representation of a signal level setting network included in both the first and second forms of the power controller.

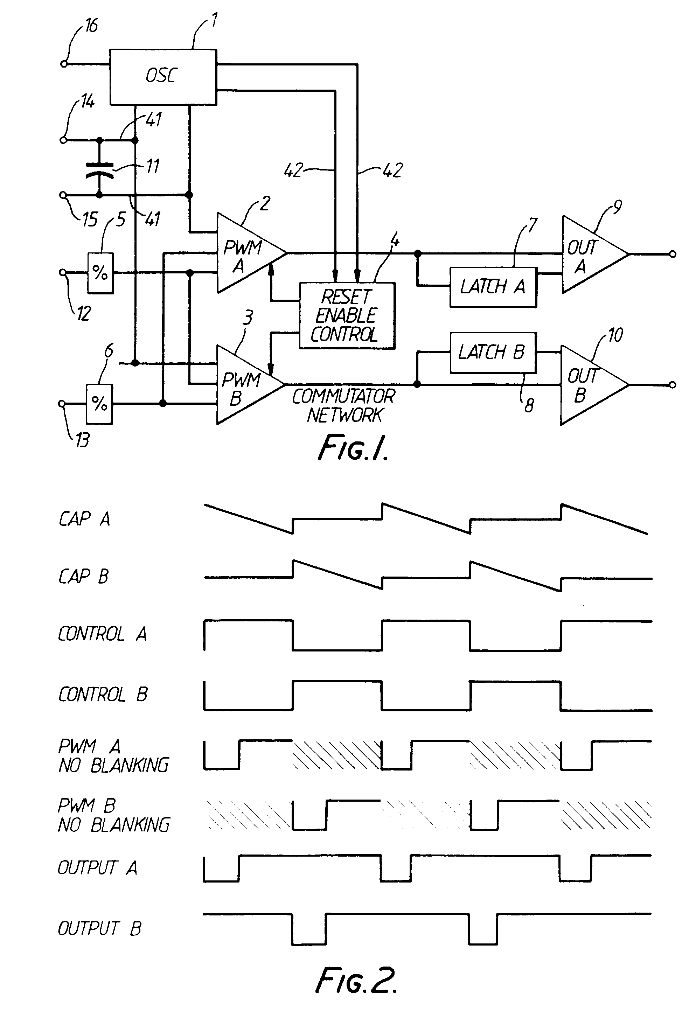

Referring to Fig. 1, the first form of the switch mode electrical power controller includes a ramp generating oscillator 1, two pulse-width modulators 2 and 3, a control network 4, signal level setting networks 5 and 6, two latching networks 7 and 8, and two output stages 9 and 10, and an external capacitor. The capacitor 11 is required for the oscillator 1.

Referring to Fig. 1, the oscillator 1 has output ports connected to input ports of the pulse-width modulators 2 and 3, and a further output port connected to the control network 4. The control network 4 has output ports connected to the pulse-width modulators 2 and 3. The pulse-width modulator 2 has an output port connected directly to the output stage 9 and the latching network 7 is connected internally to the output stage 9 and to the output port of the pulse-width modulator 2. The pulse-width modulator 3, the output stage 10, and the latching network 8 are connected together in the same manner as the pulse-width modulator 2, the output stage 9, and the latching network 7, are connected together. The signal level setting network 5 is connected between a control input port 12 and an input port of the pulse-width modulator 2 and is connected also to an input port of the pulse-width modulator 3. The signal level setting network 6 is connected between a control input port 13 and the pulse-width modulators 2 and 3 in a manner similar to the connection of the level setting network 5 to the pulse width modulators 2 and 3.

The operation of the switch mode power controller of Fig. 1 may be understood by referring to Fig. 2 in which the waveforms labelled CAP A and CAP B represent the signals provided by the oscillator 1 at the input ports to the pulse-width modulators 2 and 3, the waveforms labelled CONTROL A and CONTROL B represent the signals provided by the control network 4 to the pulse-width modulators 2 and 3, the waveforms labelled PWMA and PWMB represent the output signals from the pulse-width modulators 2 and 3, and the waveforms labelled OUTPUT A and Output B represent the signals from the output stages 9 and 10.

Referring to Fig. 2, the waveform CAP A includes alternate falling ramp portions and constant level portions and the waveform CAP B has the same form as the waveform CAP A but is shifted from it in time by a half-period of either waveform. The waveform PWM A is shown as having half-periods corresponding to the ramp portions of the waveform CAP A but is initially at a low level and changes abruptly to a high level during the existence of the ramp portion of the waveform CAP A. The change in the level of the waveform PWMA will occur at the time when the input signal on one of the control input ports 12 and 13 is such that the signal at a second of the input ports of the pulsewidth modulator 2 is equal to the ramp level, the waveform PWM A being low while the ramp level is the greater and the waveform being high while the ramp level is the lower, of the two signals. It will be appreciated that the ratio of the period for which the waveform PWM A is low to that when it is high will alter as the input signal on the port 12 or 13 varies. The level setting networks 5 and 6 are required to adjust the range of the signal appearing at the input ports of the pulse-width modulators 2 and 3 to match the amplitude of the ramp. The waveform PWM B is generated in a similar manner to that of PWMA. It will be noted that PWMA and PWMB are not show for the period during which the waveforms CAP A and CAP B are constant for the reason that PWMA and PWMB are meaningful only during periods when CAPA and CAPB are ramp waveforms. The waveforms CONTROL A and CONTROL B are used to set the pulse-width modulators 2 and 3 to their respective high output level states, that is, to effect blanking during those periods when CAPA and CAP B are not ramp waveforms to provide the output waveforms OUTPUT A and OUTPUT B.

The output waveforms OUTPUT A and OUTPUT B may be combined to provide a single-ended output device or the waveforms OUTPUT A and OUTPUT B may be kept separate to provide a double-ended output device.

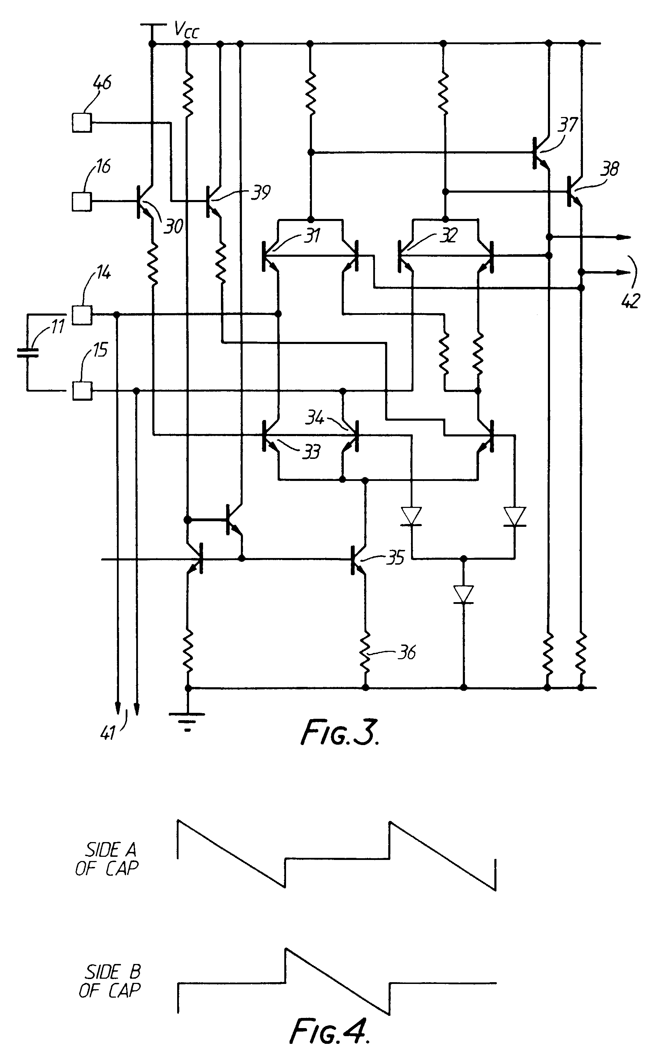

Fig. 3 is a circuit diagram representation of the oscillator of Fig. 1, and, referring to Fig. 3, the oscillator includes ports 14 and 15 between which are connected the frequency-determining capacitor (the capacitor 11 of Fig. 1). The oscillator is an integrated circuit form of a symmetrical non-saturating emitter coupled multi-vibrator in which the frequency-determining capacitor 11 is connected between the emitters of two transistors supplied by current sources and in which there are feedback connections between the transistors to cause oscillation, the two current source currents flowing first one way through the capacitor and then the other way through the capacitor to generate the ramp waveforms as the transistors switch alternately on and off (see Electronic Designer's Handbook by T. K. Hemingway pages 191 to 194). In Fig. 3, the capacitor 11 is connected to the emitters of the transistors 31 and 32 for which the transistors 33, 34 and 35 and the resistor 36 provide two current sources. The signals developed at the collector electrode of the transistor 31 are fed back to the base electrode of the transistor 32 by way of the transistor 37 and the signals at the collector electrode of the transistor 32 are fed back to the base electrode of the transistor 31, to provide cross-coupling between the output and input ports. The emitter electrode of the transistors 37 and 38 provide further output ports for the oscillator.

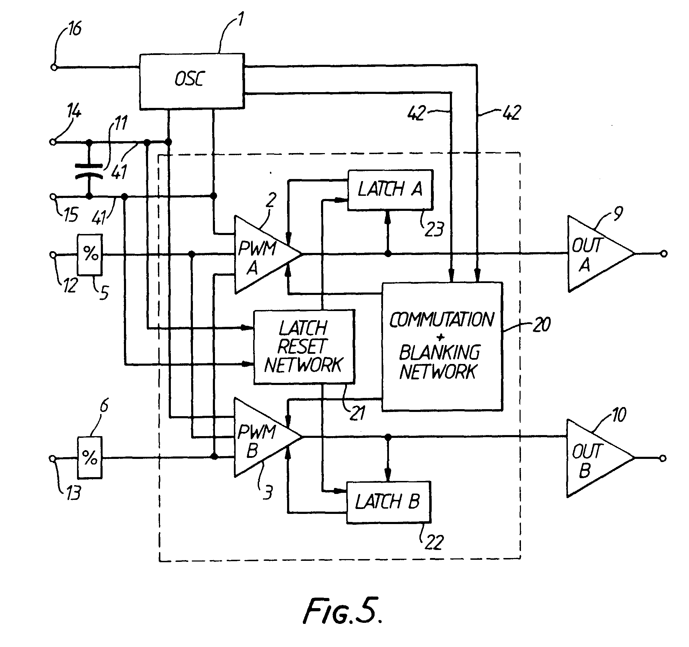

Referring to Fig. 4, waveforms of the output signals available from the port 14 of the oscillator is shown as the upper waveform, say, of Fig. 4, and the waveform of the output signal available from the port 15 of the oscillator is then the lower waveform of Fig. 4. As is evident from the two waveforms, the oscillator provides a signal in which a negative-going ramp alternates with a constant level about which the ramps are symmetrical. The waveforms or Fig. 4 are, of course, the same as the upper waveforms of Fig. 2. The oscillator includes a frequency-control input port 16 permitting control of the current source currents, and thereby the operating frequency, by way of a transistor 30.

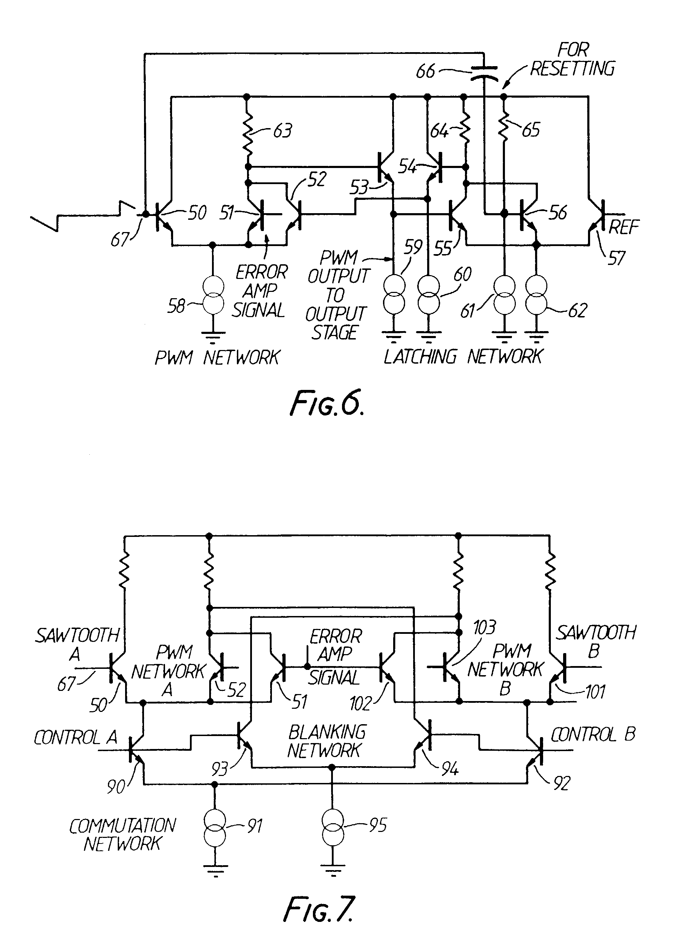

Referring to Fig. 5, the second form of the switch mode electrical controller includes, as for the first form represented by Fig. 1, a ramp qenerating oscillator 1, two pulse-width modulators 2 and 3, signal level setting networks 5 and 6, two output stages 9 and 10, and an external capacitor 11 required for the oscillator 1. The second form of the controller includes, connected to the oscillator 1 and the pulse-width modulators 2 and 3, a commutation and blanking network 20, two latching networks 22 and 23, and a latch reset network 21.

Referring to Fig. 5, the oscillator 1 has output ports connected to input ports of the pulse-width modulators 2 and 3, and a further output port connected to the commutation and blanking network 20. The commutation and blanking network 20 has output ports connected to the pulse-width modulators 2 and 3. The pulse-width modulator 2 has an output port connected directly to the output stage 9 and the latching network 23 is connected internally to the pulse-width modulator 2 and also to the output port of the pulse-width modulator 2. The latch reset network 21 has input ports connected also to the output ports of the oscillator 1 and an output port of the latch reset network 21 is connected to an input port of the latching network 23. The pulse-width modulator 3 has an output port connected directly to the output stage 10 and the latching network 22 is connected internally to the pulse-width modulator 3 and also to the output port of the pulse-width modulator 3. The latch reset network 21 has a further output port connected to an input port of the latching network 22. The signal level setting network 5 is connected between a control input port 12 and an input port of the pulse width modulator 2 and is connected also to an input port of the pulse width modulator 3. The signal level setting network 6 is connected between a control input port 13 and the pulse width modulators 2 and 3 in a manner similar to the connection of the level setting network 5 to the pulse-width modulators 2 and 3.

The operation of the second form of the switch mode power controller of Fig. 5 gives rise to the waveforms which are illustrated by Fig. 2, that is, the operation of the second form of the switch mode power controller is the same as that of the first form of the switch mode power controller.

Referring to Fig. 6, a signal processing network includes first and second transistors 50 and 51 coupled together at their emitter electrodes and sharing a current source 58 connected to the coupled emitters. A third transistor 52 is connected in parallel with the transistor 51 to share its collector load resistor 63 and the current source 58. The collector electrodes of the transistors 51 and 52 are connected to the base electrode of a fourth transistor 53 which has a current source 59 connected as its emitter load and the emitter electrode of the transistor 53 is connected to the base electrode of a transistor 55 which has a current source emitter load 62, and a collector load resistor 64. The collector electrode of the transistor 55 is connected to the base electrode of a transistor 54 which has a current source emitter load 60, the emitter electrode of the transistor 54 being connected to the base electrode of the transistor 52. A transistor 56 is connected in parallel with the transistor 55 sharing the collector load resistor 64 and the emitter current source 62. The transistor 56 is biased by means of a base resistor 65 connected between its base electrode and a positive voltage (which is the positive voltage supply for the other transistors) and a current source 61 connected between its base electrode and electrical ground. The base electrode of the transistor 56 is connected to the base electrode of the transistor 50 by way of a capacitor 66. A further transistor 57 has its emitter electrode connected to the current source 62, and its collector electrode connected to the positive supply for the other transistors. The base electrode of the transistor 57 is connected to a further resistor and a further current source similar to the connections of the base electrode of the transistor 56 to its resistor 65 and current source 61, but the further resistor and current source associated with the transistor 57 are not shown.

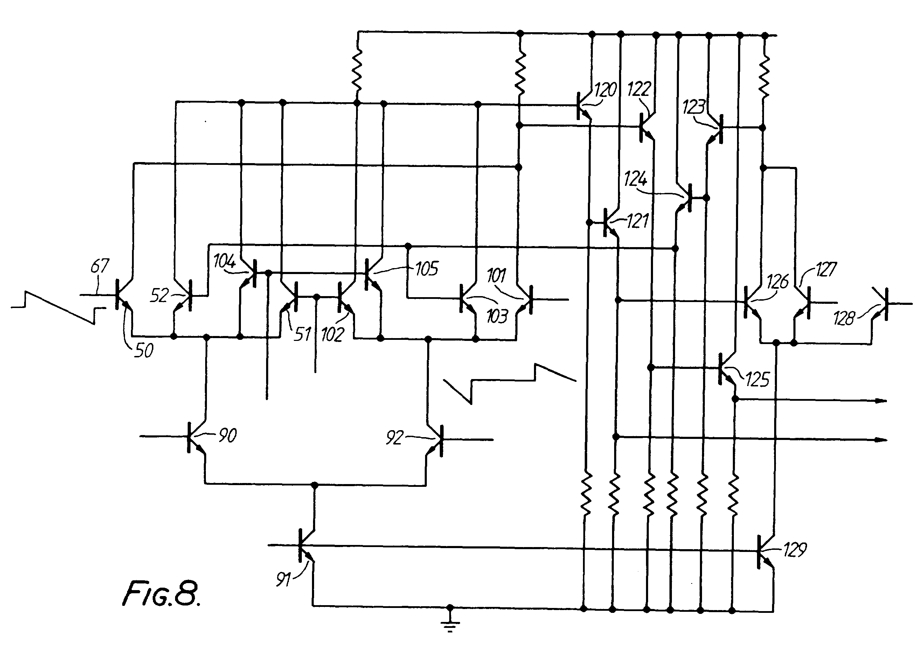

In the operation of the signal processing arrangement of Fig. 6, the base electrode of the transistor 50 receives a ramp waveform signal CAP A/B from the oscillator 1 of Fig. 1 while the base electrode of the transistor 51 receives a constant level signal which is an error voltage which will represent the difference between the desired and actual output voltages of a power supply to which the signal processing arrangement belongs. The ramp waveform CAP A/B has an initial rapid rise from the constant voltage level which precedes it and this jump in level is communicated, by way of the capacitor 66, to the base electrode of the transistor 56 causing an abrupt rise in its collector current and an abrupt drop in its collector voltage level, the collector voltage level drop being communicated to the base electrode of the transistor 52 by way of the transistor 54 to hold transistor 52 in a non-conducting state. Also the ramp voltage level will start higher than the error voltage and transistor 51 will be held in its non-conducting state so that the collectors of the transistors 51 and 52 will be at a high voltage level and the output voltage from the emitter electrode of the transistor 53 will be high. The output voltage will remain high as the ramp level falls but remains above the error signal level but as the ramp level goes below the error signal level the transistor 51 will begin to conduct and its collector voltage will drop. The drop in the collector voltage of the transistor 51 will be communicated to the transistors 53 and 55 as a voltage drop and to the transistors 54 and 52 as a voltage rise, causing a regenerative effect resulting in the rapid switch on of the transistor 52 and the latching of the feedback loop with the transistor 52 in its conducting state. In due course the transistor 51 will become fully conductive and will remain so to the end of the ramp waveform at which time the ramp waveform changes abruptly to the constant level which may lie below the error voltage level and as a result of which the transistor 51 may not be switched off and may cause the output voltage to remain low after the end of the ramp waveform so that the output state of the arrangement of Fig.6 is undefined during the period between the ramp waveforms. It is important that the output voltage from the signal processing arrangement should return to a high level at the end of the ramp waveform and this is ensured by the control of the current source 58 to switch off the transistor 51 at the end of the ramp waveform. Such control of the current source is illustrated by the Fig. 7 arrangement.

Referring to Fig. 7, a signal processing arrangement includes the "left-hand" transistors 50, 51 and 52 as described in Fig. 6 and corresponding "right-hand" transistors 101, 102 and 103 sharing a current source 91 connected in the emitter circuit of the transistors 50, 51 and 52 by way of of a transistor 90 and connected in the emitter circuit of the transistors 101, 102 and 103 by way of a transistor 92. The base electrode of the transistor 90 is connected to the base electrode of a transistor 93 the emitter electrode of which is connected to a current source 95 and the base electrode of the transistor 92 is connected to the base electrode of a transistor 94 the emitter electrode of which is also connected to the current source 95. The collector electrode of the transistor 93 is connected to the collector electrode of the transistors 102 and 103 and the collector electrode of the transistor 94 is connected to the collector electrode of the transistors 51 and 52.

In the operation of the signal processing arrangement of Fig. 7, the base electrode of the transistor 90 is driven by the waveform CONTROL A of Fig. 2 and the base electrode of the transistor 92 is driven by the waveform CONTROL B of Fig. 2, the two waveforms being provided by the oscillator illustrated in Fig. 3 (the transistors 37 and 38 in Fig. 3 provide the waveforms CONTROL A and CONTROL B). It will be evident that the waveform CONTROL A will be such as to disable the stage comprising transistors 50, 51 and 52 by switching off transistor 90 during the periods when the CAP A waveform has a constant value, but the effect of the transistor 94 is superimposed on this and results in the collector voltage of the transistors 51 and 52 being held low, since the CONTROL B waveform controls the transistor 94. Similarly, the transistor 92 is driven by the CONTROL B waveform while the CONTROL A waveform drives the transistor 93, so the output signals from the left and right hand stages remain complementary and the stages operate alternately.

The signal processing arrangement of Fig.7 provides a dual output that is, an output for a double-ended controller. The signal processing arrangement of Fig. 7, may be converted to provide a single output by the removal of the components 93, 94 and 95 and the connection, in parallel, of the two channels.

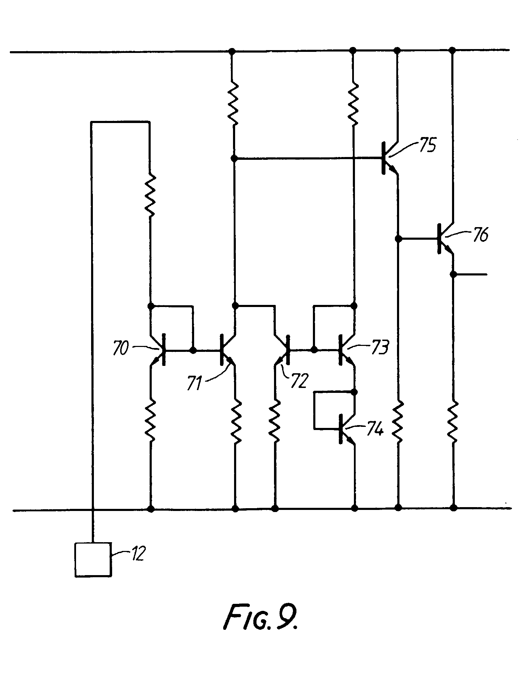

A circuit diagram representation of the circuit arrangement of Fig. 7 modified to provide a single-ended output is shown in Fig. 8 where the stages comprising the transistors 120 to 127 corresponding generally to those parts of the signal processing network represented by Fig. 6, and the stages comprising the transistors 50, 51, 52, 104, 101, 102, 103 and 105 correspond to those parts of the signal processing network represented by Fig. 7. It is to be noted that the transistors 104 and 105 provide current limiting in this arrangement and perform their function in parallel with all the other functions.

Returning to Fig. 3, it will be noted that the oscillator frequency is controllable by way of the port 16, a practical effect of which is to permit the operation of a power supply equipped with a controller comprising the voltage controllable oscillator with a variable frequency. Such operation would be achieved by an arrangement in which an error voltage was applied to the port 16, as an alternative, or in addition to an error voltage applied to the pulse-width control input port.

Referring to Fig. 9, a signal level setting network (either the network 5 or the network 6 of Fig. 1) includes a first NPN transistor 70 connected as a diode with associated collector and emitter electrode resistors, a second NPN transistor 71, connected base electrode to base electrode with the transistor 70, with its associated collector and emitter electrode resistors, a third NPN transistor 75, having its base electrode connected to the collector electrode of the transistor 71; with an associated emitter electrode resistor, and a fourth NPN transistor 76, having its base electrode connected to the emitter electrode of the transistor 75, with an associated emitter electrode resistor. A fifth NPN transistor 72 is connected collector electrode to collector electrode with the transistor 71, has an associated emitter electrode resistor, and is connected base electrode to base electrode with a sixth NPN transistor 73 which has its base and collector electrodes connected together. The transistor 73 has a collector electrode resistor and its emitter electrode is connected to a seventh NPN transistor 74 which has its base and collector electrodes connected together. The emitter electrode of the transistor 74 and the emitter electrode resistors of the transistors 70, 71, 72, 75 and 76 are connected together. Also, the collector electrode resistors of the transistors 71 and 73 are connected together and to the collector electrodes of the transistors 75 and 76. The collector electrode resistor of the transistor 70 is connected to the control input port 12, say, of Fig. 1.

In the operation of the level setting network of Fig. 9, an input control voltage to the port 12 produces a corresponding current in through the transistor 70 and its associated resistors, and the same amount of current flows through the transistor 71 and its associated emitter electrode resistor. The current flowing through the transistor 71 influences the voltage level at the junction of its collector electrode through its collector electrode resistor, and the transistors 75 and 76, which act as a compound emitter follower, communicate the voltage level of the collector electrode of the transistor 71 to the emitter electrode of the transistor 76. The emitter electrode of the transistor 76 is the output port of the level setting network. The collector voltage of the transistor 71 is also influenced by the current flowing through the transistor 72, the current flowing through the transistor 72 being set by the transistors 73 and 74 and the resistor associated with the collector electrode of the transistor 73. The output voltage level from the signal level setting circuit is therefore the combined result of a fixed current flowing through the transistor 72 and a signal-dependent current flowing through the transistor 71. The maximum output voltage level will be set by the fixed current when the signal-dependent current is zero and the minimum output voltage level will be set by the collector and emitter electrode resistors of the transistor 71, intermediate output voltage levels being in proportion to the signal applied to the control port 12 so long as the applied signal is below the value to cause the minimum output voltage levels. The arrangement of the active components in Fig. 9 is also temperature-compensated.

The level setting network of Fig. 9 provides level shifting for interfacing with the pulse width modulator 2 or 3 of Fig. 1. It also provides division by a factor of about 10 which is controlled by the ratio of the collector and emitter resistors of the transistor 70, and linearity and good control are achieved with a sawtooth excursion of about 1 Volt. An advantage of including the level setting network is that a large error amplifier output range may be used, giving good control through high sensitivity, while a match is maintained between the sawtooth waveform amplitude and the divided down error voltage.

## Claims

1. A switch mode electrical power controller including a signal generator (1) which, in operation, provides a repetitively occurring ramp waveform signal (CAP A), a control input port (12) for receiving a control input signal which represents the required output voltage from a power supply, a signal processing network (2,4;2,20,21,23) including means (2,50,51) capable of performing pulse width modulation by combining the ramp waveform signal (CAP A) with the control input signal and at least one other signal (CONTROL A) and, from the combination, providing a repetitive output signal having a first level for a first part of its period and a second level for the remainder of its period, characterised by a first circuit arrangement (52,53,54,55,64) connecting the output of the means (2,50,51) capable of performing pulse width modulation to an input of the means (2,50,51) capable of performing pulse width modulation, a change in a first sense in the repetitive output signal being fed back by the first circuit arrangement (52,53,54,55,64) to the means (2,50,51) capable of performing pulse width modulation and reinforcing the change in the output of the means capable of performing pulse width modulation in the first sense.

2. A controller as claimed in claim 1, wherein the signal generator generates a ramp waveform that includes abrupt transitions, an additional circuit arrangement (56,66) is connected between the signal generator and the first circuit arrangement (52,53,54,55,64) and, in operation, the additional circuit arrangement (56,66) transmits the abrupt transitions of the ramp waveform signal to the means (2,50,51) capable of performing pulse width modulation for resetting the means (2,50,51) capable of performing pulse width modulation at each abrupt transition of the ramp waveform signal.

3. A controller as claimed in claim 1 or 2, wherein the means (2,50,51) capable of performing pulse width modulation includes a comparator (50,51,63) providing inverting and non-inverting input ports and the first circuit arrangement (52,53,54,55,64) is connected between the output port and a non-inverting input port of the comparator (50,51,63).

4. A controller as claimed in claim 3, wherein a buffer stage (53) connects the output port of the comparator (50,51,63) to the first circuit arangement (52,53,54,55,64).

5. A controller as claimed in claim 1, wherein the signal processing network includes an output stage (9) providing an input port which is connected directly to the output port of the means (2,50,51) capable of performing pulse width modulation, a feedback network (7) connecting an input port of the means (2) capable of performing pulse width modulation to the output stage (9) and a feedforward network (4) connecting the signal generator (1) to an input port of the means (2) capable of performing pulse width modulation.

6. A controller as claimed in claim 5, wherein the feedback network (7) includes input regions of the output stage (9).

7. A controller as claimed in any one of claims 1 to 6, wherein the signal processing network includes similar first and second channels for providing respective first and second output signals on the first and second channels, and commutation and blanking networks (90,91,92,93,94,95) are connected in shunt with the signal processing network for selecting either the first or the second output signal for transmission to an output port of the controller.

8. A controller as claimed in any one of claims 1 to 6, wherein the signal processing network includes first and second channels for providing respective first and second output signals on the first and second channels, and a commutation network (120,121,122,125) is connected in shunt with the signal processing network for combining the first and the second output signals for transmission to an output port of the controller.

9. A controller as claimed in any one of claims 1 to 8, wherein the signal generator (1) is a non-saturating emitter-coupled multivibrator.

10. A controller as claimed in any one of claims 1 to 9, wherein the signal processing network includes current and voltage limit protection networks (104,105) connected in shunt with the remainder of the signal processing network.

11. A controller as claimed in any one of claims 1 to 10, wherein the signal processing network includes a plurality of differentially-connected transistor stages with common-mode input ports, differential-mode input ports and differential mode output ports.

12. A controller as claimed in any one of claims 1 to 11, wherein the signal processing network includes a signal level setting network (70 to 76) connected to adjust the control signal range.

## Patentansprüche

1. Elektrischer Leistungsschaltregler, umfassend einen Signalgenerator (1), der im Betrieb ein wiederholt auftretendes Sägezahnsignal (CAP A) liefert, einen Steuereingangsanschluß (12) zum Empfang eines Steuereingangssignals, das die geforderte Ausgangsspannung von einer Stromversorgung darstellt, ein Signälverärbeitungsnetzwerk (2,4;2, 20,21,23), das Mittel (2,50,51) umfaßt, die in der Lage sind, eine Impulsbreitenmodulation durch Kombinieren des Sägezahnsignals (CAP A) mit dem Steuereingangssignal und wenigstens einem anderen Signal (CONTROL A) durchzuführen und durch die Kombination ein sich wiederholendes Ausgangssignal zu liefern, das einen ersten Pegel für einen ersten Teil seiner Periode und einen zweiten Pegel für den Rest seiner Periode aufweist, gekennzeichnet durch eine erste Schaltkreisanordnung (52,53,54, 55,64), die den Ausgang der Mittel (2,50,51) zur Vornahme der Impulsbreitenmodulation mit einem Eingang der Mittel (2,50,51) zur Vornahme der Impulsbreitenmodulation verwendet, wobei eine Änderung in einem ersten Sinn in dem sich wiederholenden Ausgangssignal durch die erste Schaltkreisanordnung (52,53,54,55,64) zu den Mitteln (2,50,51) zur Vornahme der Impulsbreitenmodulation zurückgekoppelt wird und die Änderung im Ausgang der Mittel zur Vornahme der Impulsbreitenmodulation im ersten Sinne verstärkt.

2. Regler nach Anspruch 1, wobei der Signalgenerator eine Sägezahnwellenform erzeugt, die abrupte Übergänge umfaßt, wobei eine zusätzliche Schaltkreisanordnung (56,66) zwischen den Signalgenerator und der ersten Schaltkreisanordnung (52,53,54,55,64) geschaltet ist und im Betrieb die zusätzliche Schaltkreisanordnung (56,66) die abrupten Übergänge des Sägezahnsignals auf die Mittel (2,50,51) zur Vornahme der Impulsbreitenmodulation zum Rückstellen der Mittel (2,50,51) zur Vornahme der Impulsbreitenmodulation bei jedem abrupten Übergang des Sägezahnsignals überträgt.

3. Regler nach Anspruch 1 oder 2, wobei die Mittel (2,50,51) zur Vornahme der Impulsbreitenmodulation einen Komparator (50,51,63) umfassen, der invertierende und nichtinvertierende Eingangsanschlüsse liefert, und die erste Schaltkreisanordnung (52,53,54,55,64) zwischen den Ausgangsanschluß und einen nichtinvertierenden Eingangsanschluß des Komparators (50,51,63) geschaltet ist.

4. Regler nach Anspruch 3, wobei eine Pufferstufe (53) den Ausgangsanschluß des Komparators (50,51,63) mit der ersten Schaltkreisanordnung (52,53,54,55,64) verbindet.

5. Regler nach Anspruch 1, wobei das signalverarbeitende Netzwerk eine Ausgangsstufe (9), die einen Eingangsanschluß liefert, der direkt mit dem Ausgangsanschluß der Mittel (2,50,51) zur Vornahme der Impulsbreitenmodulation verbunden ist, ein Rückkopplungsnetzwerk (7), das einen Eingangsanschluß der Mittel (2) zur Vornahme der Impulsbreitenmodulation mit der Ausgangsstufe (9) verbindet, und ein Mitkopplungsnetzwerk (4) umfaßt, das den Signalgenerator (1) mit einem Eingangsanschluß der Mittel (2) zur Vornahme der Impulsbreitenmodulation verbindet.

6. Regler nach Anspruch 5, wobei das Rückkopplungsnetzwerk (7) Eingangsbereiche der Ausgangsstufe (9) umfaßt.

7. Regler nach einem der Ansprüche 1 bis 6, wobei das signalverarbeitende Netzwerk ähnliche erste und zweite Kanäle zum Liefern entsprechender erster und zweiter Ausgangssignale auf den ersten und zweiten Kanälen umfaßt und Kommutations- und Austastnetzwerke (90,91,92,93, 94,95) im Nebenschluß mit dem signalverarbeitenden Netzwerk zum Auswählen entweder des ersten oder des zweiten Ausgangssignals zur Übertragung zu einem Ausgangsanschluß des Reglers verbunden sind.

8. Regler nach einem der Ansprüche 1 bis 6, wobei das signalverarbeitende Netzwerk erste und zweite Kanäle zum Liefern entsprechender erster und zweiter Ausgangssignale auf den ersten und zweiten Kanälen umfaßt und ein Kommutationsnetzwerk (120,121,122,125) im Nebenschluß mit dem signalverarbeitenden Netzwerk zum Kombinieren der ersten und der zweiten Ausgangssignale zur Übertragung zu einem Ausgangsanschluß des Reglers geschaltet ist.

9. Regler nach einem der Ansprüche 1 bis 8, wobei der Signalgenerator (1) ein nicht sättigender Emitter-gekoppelter Multivibrator ist.

10. Regler nach einem der Ansprüche 1 bis 9, wobei das signalverarbeitende Netzwerk Strom- und Spannungsbegrenzungs-Schutznetzwerke (104,105) umfaßt, die im Nebenschluß mit dem Rest des signalverarbeitenden Netzwerks geschaltet sind.

11. Regler nach einem der Ansprüche 1 bis 10, wobei das signalverarbeitende Netzwerk eine Vielzahl von differenzmäßig verbundenen Transistorstufen mit Gleichtakteingangsanschlüssen, Differenztakteingangsanschlüssen und Differenztaktausgangsanschlüssen umfaßt.

12. Regler nach einem der Ansprüche 1 bis 11, wobei das signalverarbeitende Netzwerk ein Netzwerk (70 bis 76) zum Festsetzen des Signalpegels umfaßt, das angeschlossen ist, um den Steuersignalbereich einzustellen.

## Revendications

1. Contrôleur d'alimentation électrique à mode de commutation comprenant un générateur de signal (1) qui, en fonctionnement, applique un signal de forme d'onde en rampe apparaissant de façon répétitive (CAP A), un accès d'entrée de commande (12) destiné à recevoir un signal d'entrée de commande qui représente la tension de sortie requise d'une alimentation, un réseau de traitement du signal (2, 4 ; 2, 20, 21, 23) comprenant un moyen (2, 50, 51) capable de réaliser une modulation par largeur d'impulsion en combinant le signal de forme d'onde en rampe (CAP A) avec le signal d'entrée de commande et au moins un autre signal (CONTROL A) et, à partir de la combinaison, de fournir un signal de sortie répétitif présentant un premier niveau pendant une première partie de sa période et un second niveau pendant le reste de sa période, caractérisé par un premier agencement de circuit (52, 53, 54, 55, 64) reliant la sortie du moyen (2, 50, 51) capable d'exécuter une modulation par largeur d'impulsion à une entrée du moyen (2, 50, 51) capable d'exécuter une modulation par largeur d'impulsion, une variation dans un premier sens du signal de sortie répétitif étant renvoyée par le premier agencement de circuit (52, 53, 54, 55, 64) vers le moyen (2, 50, 51) capable d'exécuter une modulation par largeur d'impulsion et renforçant la variation de la sortie du moyen capable d'exécuter une modulation par largeur d'impulsion dans le premier sens.

2. Contrôleur selon la revendication 1, dans lequel le générateur de signal émet une forme d'onde en rampe qui comprend des transitions abruptes, un agencement de circuit supplémentaire (56, 66) est relié entre le générateur de signal et le premier agencement de circuit (52, 53, 54, 55, 64) et, en fonctionnement, l'agencement de circuit supplémentaire (56, 66) transmet les transitions abruptes du signal de forme d'onde en rampe au moyen (2, 50, 51) capable d'exécuter une modulation par largeur d'impulsion afin de remettre à zéro le moyen (2, 50, 51) capable d'exécuter une modulation par largeur d'impulsion à chaque transition abrupte du signal de forme d'onde en rampe.

3. Contrôleur selon la revendication 1 ou 2, dans lequel le moyen (2, 50, 51) capable d'exécuter une modulation par largeur d'impulsion comprend un comparateur (50, 51, 63) fournissant des accès d'entrée à inversion et sans inversion, et le premier agencement de circuit (52, 53, 54, 55, 64) est relié entre l'accès de sortie et un accès d'entrée sans inversion du comparateur (50, 51, 63).

4. Contrôleur selon la revendication 3, dans lequel un étage tampon (53) relie l'accès de sortie du comparateur (50, 51, 63) au premier agencement de circuit (52, 53, 54, 55, 64).

5. Contrôleur selon la revendication 1, dans lequel le réseau de traitement du signal comprend un étage de sortie (9) fournissant un accès d'entrée qui est relié directement à l'accès de sortie du moyen (2, 50, 51) capable d'exécuter une modulation par largeur d'impulsion, un réseau de contre-réaction (7) reliant un accès d'entrée du moyen (2) capable d'exécuter une modulation par largeur d'impulsion à l'étage de sortie (9) et un réseau d'action directe (4) reliant le générateur de signal (1) à un accès d'entrée du moyen (2) capable d'exécuter une modulation par largeur d'impulsion.

6. Contrôleur selon la revendication 5, dans lequel le réseau de contre-réaction (7) comprend les régions d'entrée de l'étage de sortie (9).

7. Contrôleur selon l'une quelconque des revendications 1 à 6, dans lequel le réseau de traitement du signal comprend des premier et second canaux similaires afin de fournir des premier et second signaux de sortie respectifs sur les premier et second canaux, et des réseaux de commutation et de suppression (90, 91, 92, 93, 94, 95) sont reliés en dérivation avec le réseau de traitement du signal afin de sélectionner soit le premier, soit le second signal de sortie en vue d'une transmission vers un accès de sortie du contrôleur.

8. Contrôleur selon l'une quelconque des revendications 1 à 6, dans lequel le réseau de traitement du signal comprend des premier et second canaux destinés à fournir des premier et second signaux de sortie respectifs sur les premier et second canaux, et un réseau de commutation (120, 121, 122, 125) est relié en dérivation avec le réseau de traitement du signal en vue de combiner le premier et le second signal de sortie pour une transmission vers un accès de sortie du contrôleur.

9. Contrôleur selon l'une quelconque des revendications 1 à 8, dans lequel le générateur de signal (1) est un multivibrateur à émetteur couplé non saturant.

10. Contrôleur selon l'une quelconque des revendications 1 à 9, dans lequel le réseau de traitement du signal comprend des réseaux de protection à limitation de courant et de tension (104, 105) reliés en dérivation avec le reste du réseau de traitement du signal.

11. Contrôleur selon l'une quelconque des revendications 1 à 10, dans lequel le réseau de traitement du signal comprend un certain nombre d'étages à transistors reliés de façon différentielle avec des accès d'entrée en mode commun, des accès d'entrée en mode différentiel et des accès de sortie en mode différentiel.

12. Contrôleur selon l'une quelconque des revendications 1 à 11, dans lequel le réseau de traitement du signal comprend un réseau de réglage du niveau du signal (70 à 76) relié de façon à ajuster la plage du signal de commande.
